# EUROPEAN PATENT SPECIFICATION

(11) **EP 2 190 056 B1**
(45) Date of publication and mention of the grant of the patent: **01.10.2014**
(21) Application number: 07806434.2
(22) Date of filing: 24.08.2007
(51) Int. Cl.: H01M 14/00, H01G 9/20

(54) **DYE-SENSITIZED SOLAR CELL**
FARBSTOFFSENSIBILISIERTE SOLARZELLE
CELLULE SOLAIRE SENSIBILISÉE PAR UN COLORANT

(30) Priority: 24.08.2006 JP 2006227374; 28.08.2006 JP 2006230307; 28.08.2006 JP 2006230991
(43) Date of publication of application: 26.05.2010
(73) Proprietor: Toyo Seikan Kaisha, Ltd., Shinagawa-ku Tokyo 141-8640 (JP)
(72) Inventor: YAMAMOTO, Naotsugu, Hodogaya-ku, Yokohama-shi, Kanagawa 2400062 (JP); SATO, Kazuhiro, Hodogaya-ku, Yokohama-shi, Kanagawa 2400062 (JP)
(74) Representative: Manley, Nicholas Michael
(86) International application number: PCT/JP2007/066957
(87) International publication number: WO 2008/023848

(56) References cited:
- JP-A- 2005 142 086
- JP-A- 2005 158 726
- JP-A- 2005 158 726
- JP-A- 2005 158 727
- JP-A- 2005 158 727
- JP-A- 2005 251 591
- US-A1- 2006 219 294

## Description

### <Technical Field>

This invention relates to a dye-sensitized solar cell and, more specifically, to a dye-sensitized solar cell for generating electricity upon being irradiated with light from the side of an opposing electrode (cathode) provided opposing the negative electrode.

### <Background Art>

Solar power generation has now been greatly expected from the standpoint of environmental problems on a global scale and depletion of fossil energy resources, and single crystalline and polycrystalline silicon photoelectric converter devices have been put into practical use in solar cells. However, the solar cells of this kind are expensive and are accompanied by a problem of supplying the starting silicon material. Therefore, it has been desired to put the solar cells into practical use by using materials other than silicon.

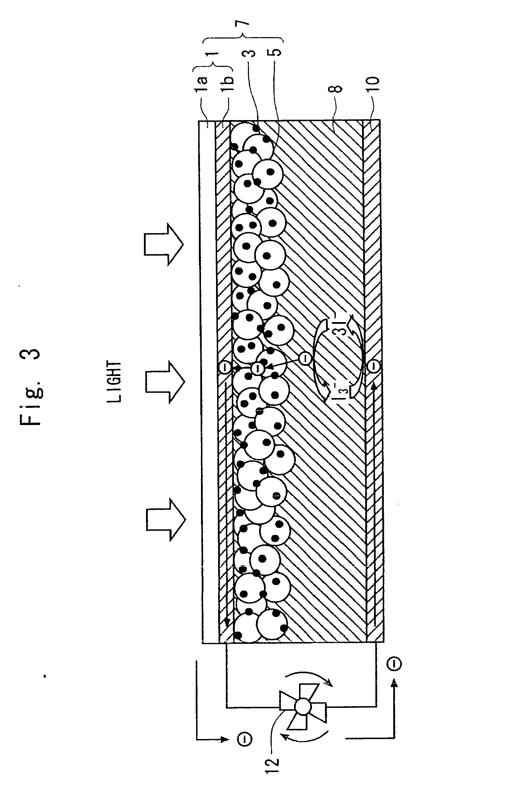

From the above point of view in recent years, a dye-sensitized solar cell is drawing attention as a solar cell using materials other than silicon. The dye-sensitized solar cell, usually, has a structure as shown in Fig. 3. That is, the solar cell has an electrode substrate 1 which comprises a transparent conducting film 1b (e.g., ITO film) formed on a transparent substrate 1a such as a transparent glass or a transparent resin film, and wherein a porous layer 3 of a metal semiconductor oxide such as titanium dioxide is provided on the transparent conducting film 1b of the electrode substrate 1, and a sensitizing dye (e.g., Ru dye) 5 is adsorbed and carried on the surface of the porous layer 3. A negative electrode structure (photoelectrode) 7 comprising the electrode substrate 1 having the semiconductor oxide layer 3 is opposed to a positive electrode 10 with an electrolyte 8 held therebetween.

In the dye-sensitized solar cell of this structure, when visible light falls on the side of the negative electrode structure 7, the dye 5 is excited and is transited from the ground state to the excited state. Electrons of the excited dye 5 are injected into the conduction band of the porous layer 3 in the semiconductor, and migrate to the positive electrode 10 through an external circuit 12. The electrons that have migrated to the positive electrode 10 return back to the dye 5 being carried by ions in the electrolyte. The electric energy is taken out through the repetition of the above process. The power generation mechanism of the dye-sensitized solar cell is different from that of the pn-junction photoelectric converter element; i.e., trapping of light and conduction of electrons occur in separate places very like that of a photoelectric conversion process of plants.

Here, when light falls on the side of the negative electrode structure 7 as described above, the transparent conducting film 1b exhibits a large resistance. If the cell unit (a minimum unit of power generation functioning as a cell) is fabricated in a large size, problems arouse such a greatly decreased internal resistance (Fill Factor; FF) and a very decreased conversion efficiency.

To solve the above problems, a patent document 1 discloses a dye-sensitized solar cell that generates electricity by permitting light to fall on the side of an electrode (positive electrode) opposing the negative electrode. In the solar cell of this structure, light does not fall on the side of the negative electrode. It is, therefore, allowed to provide a semiconductor porous layer carrying the dye directly on a metal plate of a low resistance, offering an advantage of effectively avoiding a decrease in the FF caused by an increase in the size of the cell or a decrease in the conversion efficiency.

Patent document 1: JP-A-2001-273937

JP 2005 158 726 A discloses an electrode substrate for a dye-sensitized solar cell which has a high photoelectric conversion efficiency and in which the dye-sensitized solar cell with suppressed aging drop of its performance is obtained easily at a low cost in the electrode substrate for the dye-sensitized solar cell using a transparent resin film as a substrate material.

In manufacturing the electrode substrate for the dye-sensitized solar cell formed on the transparent resin film, the transparent electrode includes: the first conductive layer of a metal appearing the shape in combination with many fine wires; a corrosion preventive layer formed of electrolytic plating or electroless plating to cover at least the outer surface of the first conductive layer; and a second conductive layer made of a metal covering the corrosion preventive layer. The corrosion preventive layer is formed of a material which has a corrosion resistance to the electrolyte for the dye-sensitized solar cell.

JP 2005 158 727 A discloses an electrode substrate for a dye-sensitized solar cell which has high photoelectric conversion efficiency, and also to provide a method for manufacturing the same and the dye-sensitized solar cell.

The electrode substrate for the dye-sensitized solar cell includes a transparent substrate, a transparent electrode formed on one side surface of this transparent substrate, a porous semiconductor electrode formed on the transparent electrode, and a dye supported to the surface of semiconductor particulate forming the porous semiconductor electrode. In manufacturing the electrode substrate for the dye-sensitized solar cell, the transparent electrode includes the first conductive layer of a metal having many openings formed in the transparent electrode, a flattened transparent layer buried in the openings of the first conductive layer to flatten or substantially flatten the first conductive layer, and a second conductive layer made of a metal oxide covering the first conductive layer and the flattened transparent layer.

### Disclosure of the Invention

The dye-sensitized solar cell that generates electricity by being irradiated with light from the positive electrode side as taught by the patent document 1, however, has a low durability accompanied by a problem of conversion efficiency that decreases within short periods of time and a problem of rectification barrier. That is, the semiconductor layer formed on the metal substrate of a low resistance chiefly comprises a dense semiconductor oxide layer formed by a sol-gel method, having incomplete rectification barrier and permitting the conversion efficiency to decrease with the passage of time.

It is, therefore, an object of the present invention to provide a dye-sensitized solar cell which generates electricity upon being irradiated with light from the side of an electrode opposing a negative electrode structure, which prevents a decrease in the fill factor (FF) caused by an increase in the size of the cell and a decrease in the conversion efficiency, featuring excellent durability, maintaining a stable conversion efficiency over extended periods of time and improving the problem of rectification barrier.

Another object, but not part of the present invention is to provide a paste for forming an semiconductor oxide layer, which is capable of forming an semiconductor oxide layer that can adsorb and carry a large amount of sensitizing dye, and can be used for the production of a dye-sensitized solar cell that exhibits a high conversion efficiency.

According to the present invention, there is provided a dye-sensitized solar cell including a negative electrode structure, an opposing electrode structure having a transparent conducting substrate, and an electrolyte layer provided between said negative electrode structure and the opposing electrode, said negative electrode structure having a metal electrode substrate and a semiconductor oxide layer carrying a dye, wherein a chemical conversion treatment film is formed on a surface of said metal electrode substrate, and said semiconductor oxide layer is formed on said chemical conversion treatment film and wherein the metal electrode substrate is made from aluminum or iron;

In the dye-sensitized solar cell of the present invention, it is desired that:
(a) the chemical conversion treatment film has a thickness in a range of 5 to 500 nm;
(b) the semiconductor oxide layer, when the surface thereof is observed by using an electron microscope, has pore sizes of project area of not smaller than 10,000 nm² in a number of 5 to 80% of all pores in the surface thereof of a size of an area of 1 µm x 1 µm; and
(c) the semiconductor oxide layer has a thickness of 1 to 15 µm.

Also described, but not forming part of the present invention, is a paste for forming an semiconductor oxide layer in a dye-sensitized solar cell, including fine titanium oxide particles, a titanium binder, an organic solvent, and a porosity promotor which is a higher alcohol having not less than 5 carbon atoms.

In the paste for forming an semiconductor oxide layer, it is desired that:
(e) the fine titanium oxide particles have a particle diameter of 5 to 500 nm;
(f) the titanium binder is contained in an amount of 5 to 60 parts by weight per 100 parts by weight of the fine titanium oxide particles;
(g) glycol ether and/or β-diketone is contained as a modifying agent, and the titanium isoproxide is at least partly modified with the modifying agent;
(h) the modifying agent is contained in an amount of 0.01 to 30 parts by weight per 100 parts by weight of the titanium isopropoxide;
(i) the organic solvent is a lower alcohol having not more than 4 carbon atoms;
(j) the porosity promotor is contained in an amount of 0.01 to 50 parts by weight per 100 parts by weight of the fine titanium oxide particles; and
(k) the paste has a solid component concentration of 10 to 50% by weight.

The dye-sensitized solar cell of the present invention generates electricity by being irradiated with light from the side of the electrode opposed to the negative electrode structure. Therefore, the semiconductor oxide layer carrying the dye is provided on the electrode substrate (negative electrode) without interposing a high-resistance film such as a transparent conducting film. As a result, even when fabricated to possess a large area, the cell exhibits an FF (fill factor) and a conversion efficiency which are little different from when the cell is fabricated to possess a small area.

According to the present invention, further, the chemical conversion treatment film is formed on the surface of the metal electrode substrate (negative electrode) in the negative electrode structure, and the semiconductor oxide layer is formed on the chemical conversion treatment film. That is, the chemical conversion treatment film works as an inverse current-preventing layer, forms a stable rectification barrier and, therefore, effectively avoids a decrease in the conversion efficiency. Moreover, the chemical conversion treatment film has a high resistance against the electrolyte, and effectively prevents the metal electrode substrate (negative electrode) from being deteriorated by corrosion caused by the electrolyte between the negative electrode structure and the opposing electrode (positive electrode). As a result, durability is improved and a high conversion efficiency can be maintained for extended periods of time.

Moreover, the chemical conversion treatment film on the metal electrode substrate can be continuously and easily formed by chemical conversion treatment coating unlike the vapor-deposited film that is formed by a batch system using an expensive apparatus. Therefore, the dye-sensitized solar cell of the present invention can be produced very highly efficiently.

Further, the paste for forming the semiconductor oxide layer can be applied onto the metal electrode substrate (negative electrode) and fired to form an semiconductor oxide layer having a high degree of porosity.

That is, upon using the above paste, the semiconductor oxide layer of the dye-sensitized solar cell that is irradiated with light from the side of the opposing electrode has pore sizes of project area of not smaller than 10,000 nm² in a number of 5 to 80% of all pores in the horizontal cross section of a size of an area of 1 µm x 1 µm and, therefore, has a high porosity making it possible to carry a large amount of sensitizing dye and, accordingly, further improving the conversion efficiency. For example, when a paste containing no porosity promotor (alcohol having not less than 5 carbon atoms) is used, the above porosity cannot be realized. Therefore, a relatively dense semiconductor oxide layer is formed without almost forming pores of the above sizes, and the result becomes unsatisfactory from the standpoint of enhancing the conversion efficiency.

### Description of the Drawings

Fig. 1 is a view schematically illustrating the structure of a dye-sensitized solar cell of the present invention.
Fig. 2 is a view illustrating, on an enlarged scale, a major portion of another embodiment of the dye-sensitized solar cell of the present invention.
Fig. 3 is a view schematically illustrating the structure of a conventional known dye-sensitized solar cell.
Fig. 4 is a diagram plotting current densities and open-circuit voltages of the dye-sensitized solar cells of Example 1 and Comparative Example 1.

### Best Mode for Carrying Out the Invention

The invention will now be described in detail with reference to the accompanying drawings.

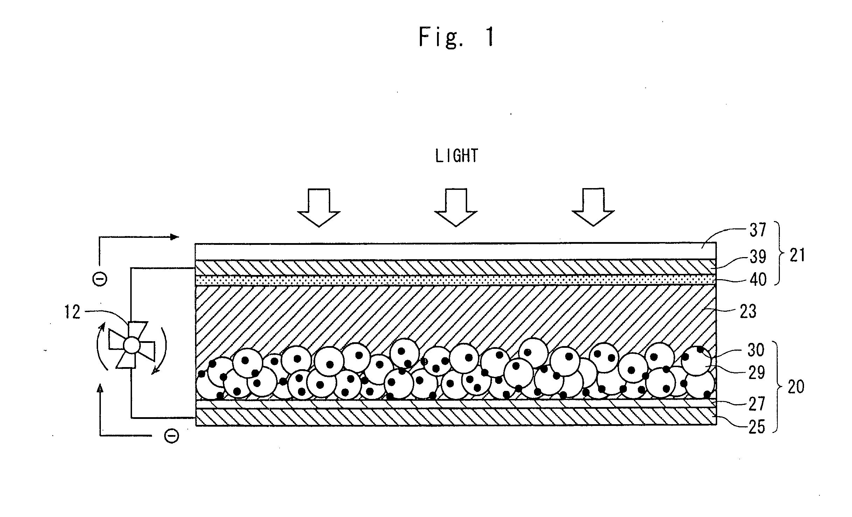

Referring to Fig. 1, the solar cell of the invention includes a negative electrode structure generally designated at 20 and an opposing electrode (positive electrode) structure generally designated at 21, and an electrolyte 23 is arranged between these electrode structures 20 and 21. Visible light falls on the negative electrode structure 20 upon being irradiated from the side of the opposing electrode structure 21 to generate electricity.

As the electrolyte 23, there can be used various electrolytes containing cations such as lithium ions and anions such as chlorine ions like those of known solar cells. It is, further, desired that the electrolyte 23 contains oxidation-reduction pairs that are capable of reversibly assuming the oxidation type structure and the reduction type structure. As the oxidation-reduction pairs, there can be exemplified an iodine-iodine compound, a bromine-bromine compound, and a quinone-hydroquinone. The above electrolyte 23 is, usually, sealed with an electrically insulating resin so will not to leak out from between the electrode structures 20 and 21.

It is, further, allowable to use a gel electrolyte or a solid electrolyte in addition to the liquid electrolyte. As the gel electrolyte, there can be exemplified a physical gel which is gelled near room temperature due to a physical interaction, such as polyacrylonitrile or polymethacrylate, and a chemical gel forming a gel due to chemical bond of a crosslinking reaction of an acrylic ester system or a methacrylic ester system. As the solid electrolyte, there can be exemplified a polypyrrole or a CuI. When the gel electrolyte or the solid electrolyte is used, the semiconductor oxide layer is impregnated with a precursor of a low viscosity, and a two-dimensional or a three-dimensional crosslinking reaction is effected by such means as heating, ultraviolet-ray irradiation or electron ray irradiation to attain the gelation or solidification. From the standpoint of power generation efficiency, however, it is desired to use an electrolyte.

### (Negative Electrode Structure 20)

The negative electrode structure 20 has a metal substrate 25 that works as a negative electrode. An semiconductor oxide porous layer (hereinafter simply referred to as a semiconductor porous layer) 29 is formed on the metal substrate 25 via a chemical conversion treatment film 27. The semiconductor porous layer 29 carries a dye 20 which is a sensitizing agent. As shown in Fig. 1, the semiconductor porous layer 29 carrying the dye 30 is opposed to the opposing electrode structure 21, and is in contact with the electrolyte 23.

That is, in the solar cell of the invention, the dye 30 is excited by the irradiation with visible light from the side of the opposing electrode 21. Electrons of the excited dye 30 are injected into the conduction band of the semiconductor porous layer 29, migrate from the metal substrate 25 to the positive electrode structure 21 through an external load 31, and return back to the dye 30 being carried by ions in the electrolyte 23. Through the repetition of the above process, the electric energy is taken out from the external load 31. The above mechanism of power generation itself is basically the same as the one which is irradiated with light from the side of the negative electrode structure 20 except that light falls on the side of the opposing electrode structure 21.

According to the present invention, light falls on the side of the opposing electrode structure 21 and, therefore, the negative electrode 20 side does not have to be transparent. Accordingly, the metal substrate 25 of a low resistance is provided on the side of the negative electrode 20 eliminating the need of forming a transparent conducting film, which is a great advantage.

That is, to excite the dye 30 by being irradiated with light from the side of the negative electrode structure 20, the semiconductor porous layer 29 must be formed on the transparent conducting film such as of ITO, but cannot be provided on the metal substrate 25 which does not permit light to pass through. However, the transparent conducting film such as of ITO has a high electric resistance, and maintains a high conversion efficiency and a high internal resistance (FF) when the cell has a small area, but permits the conversion efficiency and the FF to decrease greatly when the cell is fabricated having a large area.

According to the solar cell of the present invention which is irradiated with light from the side of the opposing electrode structure 21, on the other hand, the semiconductor porous layer 29 is provided on the metal substrate 25 via the chemical conversion treatment film 27 but interposing no transparent conducting film such as of ITO therebetween, avoiding high resistance on the side of the negative electrode structure 20. Even when the cell is fabricated to possess a large area, therefore, a decrease in the FF and in the conversion efficiency is effectively prevented.

### Metal Substrate 25

In the present invention, there is no particular limitation on the metal substrate 25 provided for the above negative electrode structure 20 if it is made from a metal material having a low electric resistance. Generally, however, there is used the metal substrate of a metal or an alloy having a resistivity of not larger than 6 x 10⁻⁶ Ω · m, such as aluminum, iron (steel) or copper. From the standpoint of easy conversion treatment, in particular, the metal substrate of aluminum or iron is preferably used and, most preferably, the metal substrate of aluminum is used. There is no particular limitation on the thickness of the metal substrate 25; i.e., the metal substrate 25 may have a thickness which is capable of maintaining a suitable mechanical strength. If the productivity is not taken into consideration, the metal substrate may be formed on a resin film by, for example, vacuum evaporation. The substrate such as the resin film does not have to be transparent, as a matter of course.

### Chemical conversion treatment film 27

In the present invention, further, a chemical conversion treatment film 27 is formed on the surface of the metal substrate 25, and the semiconductor porous layer 29 is provided via the chemical conversion treatment film 27. Provision of the chemical conversion treatment film 27 brings about a distinguished effect from the standpoint of rectification barrier and the durability. That is, the chemical conversion treatment film 27 chiefly comprises an oxide and has a higher resistance than the metal substrate 25, blocking the inverse current (inverse migration of electrons), serving as an effective rectification barrier and, therefore, improving the conversion efficiency.

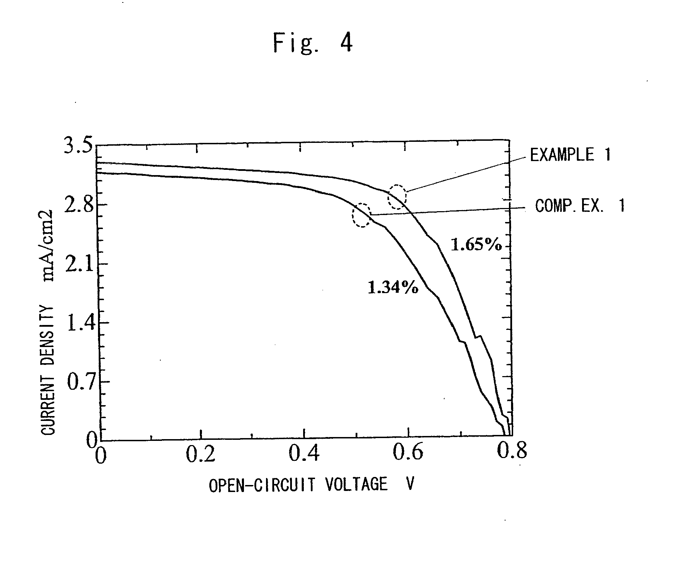

Reference should be made, for example, to Fig. 4 which shows the experimental results of Example 1 and Comparative Example 1 appearing later. Fig. 4 is a diagram plotting current densities and open-circuit voltages of Example 1 in which the semiconductor porous layer 29 is provided on the metal substrate (made of aluminum) 25 via the chemical conversion treatment film 27 and of Comparative Example 1 in which the semiconductor porous layer 29 is provided directly on the metal substrate 25. According to Fig. 4, when the electric current flows in the same amount, the open-circuit voltage is higher in the case of Example 1 than in the case of Comparative Example 1. That is, in Comparative Example 1, an inverse current flows in large amounts and, therefore, the open-circuit voltage is low. In Example 1, on the other hand, the amount of inverse current is very small and, therefore, the open-circuit voltage is high and the conversion efficiency is high, too. In Example 1, for instance, the conversion efficiency is 1.65% while in Comparative Example 1, the conversion efficiency is 1.34% and is lower than that of Example 1.

Further, chemical conversion treatment film 27 has an excellent resistance against the electrolyte 23 and, therefore, improves the durability of the solar cell and stably maintains a high conversion efficiency for extended periods of time. When, for example, the semiconductor porous layer 29 is provided directly on the metal substrate 25 without forming the chemical conversion treatment film 27, the metal substrate 25 comes into contact with the electrolyte 23 through the porous film 29. Therefore, the metal substrate 25 is deteriorated due to corrosion, impairing the durability of the solar cell, and permitting the conversion efficiency to decrease within short periods of time, which is inconvenient. In particular, metal materials having low resistances tend to be corroded by the electrolyte 23 to a conspicuous degree. The above inconvenience can be effectively avoided by interposing the chemical conversion treatment film 27 having excellent durability against the electrolyte 23 between the metal substrate 25 and the semiconductor porous layer 29.

In the present invention, the chemical conversion treatment film 27 can be formed by a known chemical conversion treatment coating. That is, in the chemical conversion treatment coating, a film basically precipitates on the surface of a metal from an aqueous solution due to a chemical reaction. In addition to the above reaction type chemical conversion treatment coating, a method called application type has recently been developed according to which a coating solution of a predetermined composition is applied, heated and dried to form an insolubilized film. The chemical conversion treatment film 27 of the invention may be formed by either method.

When, for example, either the reaction type method or the application type method is used, too, the films that are formed can be roughly grouped into the chromium type films and the non-chromium type films. The chromium type films, usually, have a high corrosion resistance while the non-chromium type films have a poor corrosion resistance but have such advantages as exerting less load on environment and featuring high adhesiveness to the metal substrate. In the present invention, the chromium type film is particularly preferred.

Referring, for example, to the chemical conversion treatment coating of aluminum, the chromium type films of the reaction type can be represented by those formed by an alkali/chromate method, a chromate method, and a phosphoric acid/chromate method.

The alkali/chromate method includes an MBV method of chemically forming a film by the treatment with an aqueous solution containing sodium carbonate, sodium chromate or sodium hydroxide as a chief component at a high temperature, an EW method of forming a film by the treatment with an aqueous solution containing sodium carbonate, sodium chromate or sodium silicate (water glass) at a high temperature, and a Pylimin method of chemically forming a film by the treatment with an aqueous solution containing sodium carbonate, sodium chromate, basic chromium carbonate or potassium permanganate at a high temperature. In any case, the film composition chiefly comprises Al₂O₃ or Cr₂O₃.

The chromate method is a method of chemically forming a film by dipping a metal substrate in an aqueous solution which contains a chromate or a bichromate as a chief component and to which a fluoride is added, as required. In a promotion system, CN ions are further added into the aqueous solution. The film, generally, has a composition of chiefly,

Cr(OH)₂ · HCrO₄, Al(OH)₂·2H₂O

The promotion system, further, contains CrFe(CN)₆ in the film.

The phosphoric acid/chromate method is a method of forming a film by using an aqueous solution of chromate or bichromate containing phosphoric acid and, as required, a fluoride is added into the aqueous solution. The film formed by this method chiefly comprises CrPO₄, AlPO₄, AlO(OH).

The non-chromium type film by the reaction type method can be represented by those formed by a boehmite method, a zinc phosphate method and a non-chromate conversion treatment. The boehmite method is a method of forming a film on the surface by the treatment with pure water of a high temperature or saturated water vapor (a small amount of triethanolamine or ammonia water is often added as a film promotor). Depending upon the temperature of treatment, the composition of film chiefly comprises Al₂O₃ · 3H₂O (bayerite) or Al₂O₃ · H₂O (boehmite). Further, the zinc phosphate method is a method of forming a film by treating the surface of the metal substrate with an aqueous solution containing zinc phosphate, nitrate and fluoride at a low temperature. The composition of film chiefly comprises Zn₃(PO₄)₂ · 4H₂O or AlPO₄. The non-chromate chemical conversion treatment coating treatment method is a method of forming a film by treating the surface of the metal substrate with an aqueous solution containing an organometal such as methylated product of Ti or Zr, phosphoric acid, nitric acid or tannic acid. The composition of film chiefly comprises, for example, Me(OH)PO₄ · Al₂O₃ or Al(Me-chelate).

On the other hand, the application type method is a method of applying a coating solution in which a metal oxide of chromium, zirconia or titanium or colloidal silica is dispersed or applying a solution (coating liquid) of a coupling agent such as silane coupling agent onto an acrylic resin such as polyacrylic acid by using a roller followed by drying to form an insolubilized film. When the chemical conversion treatment film 27 is to be formed by the above method, it is desired to use a coating solution without containing resin to form a film without containing resin. That is, when the chemical conversion treatment film 27 contains a resin component, the resin component volatilizes at the time of forming a semiconductor porous layer 29 that will be described later by firing. As a result, the effect for preventing the inverse current and the resistance against the electrolyte are impaired.

According to the present invention as described above, the chemical conversion treatment film 27 may be the reaction type or the application type, and either film can be continuously formed by dipping in the treating solution, by spraying or by being applied using a roller, offering a great advantage from the standpoint of productivity without using any particularly expensive apparatus required by the vacuum evaporation. Particularly, when the chemical conversion treatment film 27 of the application type is to be formed, no washing treatment is required, such as washing with water after the film is formed, which is particularly desirable from the standpoint of productivity.

In the present invention, further, it is desired that the thickness of the chemical conversion treatment film 27 is as small as possible so far as a suitable degree of rectification barrier (property for preventing inverse current) and corrosion against the electrolysis are maintained. Though also dependent upon the composition of the film 27, it is, usually, desired that the thickness thereof is not larger than 1,000 nm, particularly, in a range of 5 to 500 nm and, most desirably, 5 to 100 nm.

### Semiconductor Porous Layer 29

The semiconductor porous layer 29 formed on the chemical conversion treatment film 27 has heretofore been used for the dye-sensitized solar cells and, concretely, is formed by using an oxide of a metal such as titanium, zirconium, hafnium, strontium, tantalum, chromium, molybdenum or tungsten, or a composite oxide containing these metals, such as perovskite type oxide like SrTiO₃ or CaTiO₃ having a thickness of, usually, about 3 to about 15 µm.

Further, the semiconductor porous layer 29 must be porous for carrying the dye 30 and, desirably, has a relative density of 50 to 90% and, particularly, about 50 to about 70% as measured by the Archimedes' method to maintain a large surface area and to carry the dye in an effective amount.

The semiconductor porous layer 29 can be formed by using a paste obtained by dispersing fine particles of an semiconductor oxide such as titanium oxide in an organic solvent, and applying the paste onto the above chemical conversion treatment film 27 followed by firing. It is, particularly, desired to use the paste that is obtained by dispersing, in an organic solvent, fine particles of the titanium oxide together with a titanium type binder and a porosity promotor from the standpoint of attaining a high degree of porosity and carrying the dye in large amounts.

### Paste for Forming Semiconductor Porous Layer

It is desired that the fine titanium oxide particles used for forming the paste has a particle diameter in a range of 5 to 500 nm and, particularly, 5 to 350 nm from the standpoint of attaining porosity.

The titanium binder condenses with the fine titanium oxide particles to form a gel thereof, and binds the fine titanium oxide particles together to render them porous. The titanium binder is desirably an alkoxide of a lower alcohol having not more than 4 carbon atoms from the standpoint of easily forming a gel and, particularly, an isopropoxide and, most desirably, a titanium isopropoxide(tetratitanium isopropoxide).

The titanium binder is, usually, used in an amount of 5 to 60 parts by weight and, particularly, 10 to 50 parts by weight calculated as titanium alkoxide per 100 parts by weight of the fine titanium oxide particles. If the amount thereof is small, gelation is not effectively attained making it difficult to form an effective semiconductor oxide layer. If used in amounts larger than the above range, on the other hand, it becomes difficult to attain porosity.

Further, the titanium binder may be at least partly modified with a modifying agent. For modification, the modifying agent may be added to the paste of the present invention. As the modifying agent, there can be exemplified glycol ether or β-diketone such as acetyl acetone, which may be added in a single kind or in a plurality of kinds in combination.

That is, the glycol ether effects the modification upon substituting for part of the alkoxyl groups of the titanium binder, and the β-diketone effects the modification upon forming a chelate bond with part of the titanium atoms in the titanium binder. The modification promotes the gelation at the time of firing. Further, the modifying agents have relatively large molecular sizes and, therefore, contribute together with the porosity promotor that will be described later to forming large pores at the time of volatilization by firing, and exhibit the action for promoting the porousness. The modifying agent is, for example, the β-diketone.

The above modifying agent is used, desirably, in an amount of 0.01 to 30 parts by weight and, particularly, 0.05 to 10 parts by weight per 100 parts by weight of the titanium isopropoxide. When the modifying agent is used in the above amount, the porosity can be attained most effectively.

Further, as the porosity promotor, there can be used an alcohol having not less than 5 carbon atoms, such as pentanol, hexanol, heptanol, octanol, nonanol, decanol or dodecanol, in a single kind or in a combination of two or more kinds. That is, these porosity promotors have suitable degrees of volatility as well as relatively large molecules. At the time of being volatilized by firing the paste, therefore, the porosity promotor forms large pores in the gelled body making it possible to form the above-mentioned porous semiconductor oxide (titanium oxide) layer having many pores of large sizes. For example, when the porosity promotor is not used, the porous semiconductor layer 29 having large pores cannot be formed.

The above porosity promotor is used, desirably, in an amount of 0.01 to 50 parts by weight and, particularly, 0.5 to 10 parts by weight per 100 parts by weight of the fine titanium oxide particles. If the amount thereof is small, it becomes difficult to form large pores in effective amounts and, therefore, becomes difficult to form the porous semiconductor layer 29. If the amount thereof is too large, on the other hand, the porosity is so promoted that the formed semiconductor oxide layer 29 becomes brittle and cannot be put to a practical use.

There is no particular limitation on the organic solvent that is used for dispersing therein the above-mentioned fine titanium oxide particles, titanium binder, porosity promoting agent and modifying agent that is used as required, provided the organic solvent is easily volatile. Usually, there can be used various ethers, cellosolve, lower alcohols having not more than 4 carbon atoms, such as methanol, ethanol, isopropanol, n-butanol, sec-butanol and t-butanol, in a single kind or in the form of a mixed solvent of two or more kinds thereof in combination. An alcohol having not more than 4 carbon atoms is particularly preferably used. In using a lower alcohol having not more than 4 carbon atoms as the organic solvent and if it is of a kind different from an alcohol forming an alkoxide in the titanium binder, it has been known that the alkoxyl groups in the titanium binder are partly substituted (i.e., modified) by the lower alcohol that is used as the organic solvent to promote the gelation.

The organic solvent may be used in such an amount that the paste exhibits a suitable coating property and is, usually, used in such an amount that the solid component concentration of the paste is in a range of 10 to 50% by weight and, particularly, 15 to 40% by weight. If the amount of the solvent is too large, the viscosity of the paste becomes low making it difficult to form a coating maintaining a stable thickness due to dripping. If the amount of the solvent is too small, the viscosity becomes high and the workability decreases.

As described already, the paste for forming a semiconductor porous layer comprising the above-mentioned components is applied onto the chemical conversion treatment film 27 of the metal substrate 25 and is fired to form the porous titanium oxide layer (semiconductor oxide layer) 29. The paste can be applied by known means such as knife coating or roll coating, and the amount of application thereof is such that a titanium oxide layer is formed maintaining a predetermined thickness (e.g., about 1 to about 15 µm) after firing.

Further, the firing and the firing time after the application should be so set that when the surface of the formed titanium oxide layer is observed by an electron microscope, pore sizes of project area of not smaller than 10,000 nm² are present in a number of 5 to 80% and, particularly, 20 to 60% of all pores in the surface thereof of a size of an area of 1 µm x 1 µm. Usually, the firing and the firing time after the application are set to be not higher than 600°C and, particularly, 250 to 500°C and for 5 minutes to 1 hour. Attention should be given to that if the temperature is unnecessarily high or continues to be unnecessarily long, the titanium oxide layer that is formed becomes dense. Due to the firing, the TiO₂ formed by the gelation (dehydrating condensation) of the above binder component bonds the fine titanium oxide particles together. Further, due to the volatilization of the porosity promotor (as well as the modifying agent), the porous semiconductor layer (titanium oxide layer) 29 is formed.

### Sensitizing Dye 30

When brought into contact with a dye solution, the semiconductor porous layer 29 formed as described above adsorbs a sensitizing dye. After adsorption, the solvent of the dye solution is removed by drying, and the semiconductor porous layer 29 can be used for the negative electrode structure 20 of the dye-sensitized solar cell. The dye solution is contacted, usually, by dipping, and the adsorption treatment time (dipping time) is, usually, about 30 minutes to about 24 hours.

There can be used a known sensitizing dye having a bonding group such as carboxylate group, cyano group, phosphate group, oxime group, dioxime group, hydroxyquinoline group, salicylate group or α-keto-enol group. There can be used those that have been disclosed in the above-mentioned patent document, such as ruthenium complex, osmium complex or ion complex without any limitation. Preferably, there can be used a ruthenium type complex such as ruthenium-tris(2,2'-bispyridyl-4,4'-dicarboxylato), ruthenium-cis-diaqua-bis(2,2'-bispyridyl-4,4'-dicarboxylato ), or indoline type organic dye from the standpoint of particularly broad absorption bands. The dye solution of the above sensitizing dye is prepared by using an alcohol type organic solvent such as ethanol or butanol, and the dye concentration is, usually, set to be about 3 x 10⁻⁴ to about 5 x 10⁻⁴ mols/l.

In the above production process, the paste containing fine particles of the semiconductor oxide is applied, fired and, thereafter, the dye is adsorbed. When the above paste is used, however, the firing can also be conducted in a low-temperature region of lower than 100°C. When the porous semiconductor layer 29 is formed by firing at such a low temperature, it is allowable to effect the firing after the dye adsorption treatment. Namely, after the paste containing the fine semiconductor particles is applied and dried, the dye solution may be brought into contact by dipping to adsorb the sensitizing dye followed by firing. The drying in this case may be natural drying by being left in the open air. As required, however, heating may be effected at a temperature of lower than 100°C.

When the dye is adsorbed prior to firing as described above, the fine semiconductor particles in the coating have not been sintered but are still present in an amorphous state offering a great advantage in that the adsorption treatment can be conducted in short periods of time. That is, the dye solution quickly infiltrates into the fine semiconductor particles, whereby the sensitizing dye is quickly adsorbed enabling the adsorption treatment to be executed in a short period of time of, for example, about 10 to about 15 minutes, i.e., enabling the adsorption treatment to be completed in less than one-half the time of when the adsorption treatment is effected after the firing, which is very excellent from the standpoint of productivity or mass productivity.

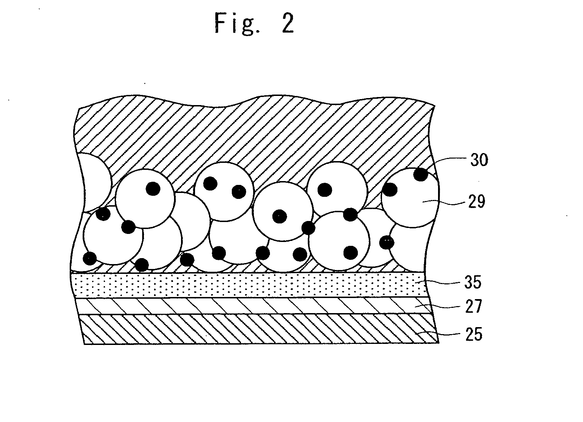

The negative electrode structure 20 in the dye-sensitized solar cell of the present invention has the structure as described above. As shown in Fig. 2 which is a view showing major portions on an enlarged scale, however, it is also allowable to provide a dense semiconductor oxide layer 35 between the semiconductor porous layer 29 and the chemical conversion treatment film 27. The dense semiconductor oxide layer 35 is formed relatively densely as compared to the above semiconductor porous layer 29, and, when the surface thereof is observed by an electron microscope, has pores of the above-mentioned size (pore sizes of project area of not smaller than 10,000 nm²) in a number of less than 5% of all pores in the surface thereof of a size of 1 µm x 1 µm.

In the present invention, the dense semiconductor layer 35 is formed in order to more reliably prevent the contact between the electrolyte 23 and the metal substrate 25, making it possible to further reliably avoid a decrease in the properties caused by corrosion by the electrolyte 23. Therefore, formation of the dense layer 35 is desirable from the standpoint of improving the durability.

It is desired that the dense semiconductor layer 35 is formed of an semiconductor oxide so will not to disturb the migration of electrons, particularly, from the semiconductor porous layer 29 to the metal substrate 25 through the chemical conversion treatment film 27. For instance, it is desired that the dense semiconductor layer 35 is formed of an semiconductor oxide of which the lower end of the conduction band is on the positive side beyond -1.0 V with the hydrogen electrode potential as a reference. As the semiconductor oxide, there can be exemplified at least one of those selected from the group consisting of cadium sulfate, potassium tantalate, cadmium selenide, strontium titanate, titanium oxide, niobium oxide, zinc oxide, iron oxide, tungsten oxide and tin oxide.

It is, further, desired that the above dense semiconductor layer 35 has a thickness of, usually, about not larger than 100 µm and, particularly, about 30 to about 500 nm to impart resistance against the corrosion by the electrolyte without decreasing the conversion efficiency.

Here, the dense semiconductor film 35 can be easily formed by preparing a paste by dispersing the fine semiconductor oxide particles described above and, as required, the binder component in an organic solvent, and applying the paste onto the chemical conversion treatment film 27 followed by firing. The particle diameter of the fine semiconductor oxide particles, the organic solvent and the binder component that is used as required, are the same as those used for forming the above-mentioned semiconductor porous layer 29. Further, the semiconductor film 35 can also be formed by using a solution of an alkoxide or a chloride capable of forming the above semiconductor oxide. In this case, the alkoxide or the chloride is added to a solvent of a lower alcohol such as ethanol or butanol, or of a polyhydric alcohol derivative such as ethylene glycol ether to prepare a solution thereof (concentration: 0.02 to 3 mols/l) and, further, adding β-diketone, β-ketoamine or β-ketoester in such amounts that the concentration thereof is 0.5 to 5 mols/l to prepare a solution thereof, and applying the solution onto the chemical conversion treatment film 27 by dipping method, spin-coating method or thermally decomposing spray-coating followed by firing. In forming the semiconductor layer 35 by any one of these methods, it is desired that the firing temperature is set to be relatively low since the dye-carrying TiO₂ layer is formed on the semiconductor layer 35 at a subsequent step and, finally, the firing is conducted at 250 to 500°C.

The dense semiconductor layer 35 can also be formed by the vacuum evaporation by using the semiconductor oxide such as TiO₂ as a target.

### (Opposing Electrode 21)

Reverting to Fig. 1, in the dye-sensitized solar cell of the present invention, the dye 30 is excited by being irradiated with light from the side of the opposing electrode (positive electrode) 21. Therefore, the opposing electrode 21 must be transparent, and has a structure in which a transparent conducting film 39 is formed on a transparent substrate 37.

As the transparent substrate 37, a transparent glass plate or a transparent resin film or sheet is used. Any transparent resin film or sheet can be used so far as it is transparent, e.g., polyolefin resins of random or block copolymers of α-olefins, such as low-density polyethylene, high-density polyethylene, polypropylene, poly 1-butene, poly 4-methyl-1-pentene, ethylene, propylene, 1-butene and 4-methyl-1-pentene; ethylene/vinyl compound copolymer resins such as ethylene/vinyl acetate copolymer, ethylene/vinyl alcohol copolymer and ethylene/vinyl chloride copolymer; styrene resins such as polystyrene, acrylonitrile/styrene copolymer, ABS and α-methylstyrene/styrene copolymer; vinyl resins such as polyvinyl alcohol, polyvinyl pyrrolidone, polyvinyl chloride, polyvinylidene chloride, vinyl chloride/vinylidene chloride copolymer, polyacrylic acid, polymethacrylic acid, methyl polyacrylate and methyl polymethacrylate; polyamide resins such as nylon 6, nylon 6-6, nylon 6-10, nylon 11 and nylon 12; polyester resins such as polyethylene terephthalate and polybutylene terephthalate; polycarbonate; polyphenylene oxide; cellulose derivatives such as carboxymethyl cellulose and hydroxyethyl cellulose; oxidized starch; starches such as etherified starch, etherified starch and dextrin; and resins of mixtures thereof. Usually, a polyethylene terephthalate film is preferably used from the standpoint of strength and heat resistance. There is no particular limitation on the thickness and size of the transparent substrate 37, and the thickness and size thereof are suitably determined depending upon the dye-sensitized solar cell that is finally used.

The transparent conducting film 39 can be represented by a film of indium oxide-tin oxide alloy (ITO film) and a film of tin oxide doped with fluorine (FTO film). Preferably, however, the ITO film is used because of its high electron-reducing property and, particularly, properties desired for the cathode. The film is formed on the transparent substrate 1a by vacuum evaporation and has a thickness of, usually, about 0.5 to about 0.7 µm.

Further, a conducting layer 40 formed on the transparent conducting film 39 may be not corroded by the electrolyte 23 and that has electron-reducing property as represented by electrically conducting high-molecular films such as a vapor-deposited Pt film, a film formed by dropping an aqueous solution of platinum chloride, PEDOT (polyethylenedioxythiophene) or PEDOT-PSS formed by doping the PEDOT with PSS (polystyrene sulfonate), and polyaniline. However, the vapor-deposited Pt film is desired having high light transmission property and high electron-reducing property. Usually, the conducting layer 40 has a thickness of about 1 to about 300 nm.

The dye-sensitized solar cell of the present invention has the negative electrode structure 20 and the opposing electrode structure 21 of structures as described above, the electrode structures 20 and 21 opposing each other with the electrolyte 23 being held therebetween as shown in Fig. 1, and the electrolyte being sealed with a resin or the like.

The dye-sensitized solar cell has the semiconductor porous layer 29 formed on the surface of the metal substrate 25 of the negative electrode structure 20 via the chemical conversion treatment film 27, and features an excellent rectification barrier, maintains a high conversion efficiency by effectively preventing the inverse current, does not permit durability to decrease that stems from the corrosion by the electrolyte 23, can be stably used for extended periods of time without losing properties, and features a stable conversion efficiency without dispersion. Further, in addition to its excellent and continuous productivity, the dye-sensitized solar cell generates electricity upon being irradiated with light from the side of the electrode structure 21 which opposes the negative electrode structure 20. It is, therefore, allowed to use the metal substrate 25 of a low resistance as a support substrate for the semiconductor porous layer 29. Accordingly, the area of the cell can be increased without decreasing the conversion efficiency or the fill factor (FF), which is very practicable. In particular, a high conversion efficiency is maintained even when the opposing electrode structure 21 (transparent substrate 37) is so designed as to possess the light-receiving surface of an area of not smaller than 1 cm x 1 cm. Moreover, the electricity is collected via the metal substrate 25 of a low resistance and, therefore, the cells can be connected without using any particular collector members such as grids, which is very advantageous from the standpoint of productivity and cost.

### EXAMPLES

### (Example 1)

A titanium isoproxide was diluted into 2 mols/L with an organic solvent (butanol) to prepare a titanium alkoxide solution. There was prepared a paste of fine titanium dioxide particles of a solid component concentration of 20% containing the above titanium alkoxide solution and the titanium dioxide particles (commercialized titania particles having a particle diameter of 15 to 350 nm) in an amount of 20 parts by weight per 100 parts by weight of the fine titanium dioxide particles.

Further, the following aluminum plate treated with the chromic phosphate was provided as an electrode substrate.

Aluminum plate:
Thickness, 0.3 mm
Chemical conversion treatment film, 50 nm

The paste of titanium dioxide prepared above was applied onto the chemical conversion treatment film of the aluminum plate and was fired at 450°C for 1 hour to form an semiconductor oxide porous layer (titanium oxide layer) having a thickness of 8 µm. The surface of the titanium oxide layer was observed by using an electron microscope and it was confirmed from its photograph that pore sizes of project area of not smaller than 10,000 nm² had been present at a ratio of 35% of all pores per an area of 1 µm x 1 µm.

On the other hand, a solution of a dye was provided by dispersing a ruthenium complex dye <[Ru(dcbpy)₂(NCS)₂] · 2H₂O> in ethanol of a purity of 99.5%, and the above semiconductor oxide porous layer was dipped in this solution of dye for 18 hours to obtain a negative electrode.

Next, an LiI/I₂ (0.5 mols/0.5 mols) was dissolved in a methoxypropionitrile and to which was, further, added a 4-tert-butylpyridine to prepare an electrolyte.

The above electrolyte was held between the negative electrode obtained above and the positive electrode of the ITO/PET film having platinum that has been vapor deposited on the surface thereof, and the circumferential edges thereof were sealed with a resin to fabricate a dye-sensitized solar cell.

The obtained solar cell was measured for its conversion efficiency as follows with a cell area of 1 cm²:
Conversion efficiency, 1.65%
FF (internal resistance), 0.62
Short-circuit current density (J_{sc}), 3.34 mA/cm²
Open-circuit voltage (V_{oc}), 0.796 V

### (Comparative Example 1)

A dye-sensitized solar cell was fabricated in quite the same manner as in Example 1 but using an aluminum plate (thickness, 0.3 mm) that has not been treated with chromate as an electrode plate (negative electrode).

The solar cell was measured for its conversion efficiency as follows with a cell area of 1 cm²:
Conversion efficiency, 1.34%
FF (internal resistance), 0.55
Short-circuit current density (J_{sc}), 3.18 mAcm²
Open-circuit voltage (V_{oc}), 0.766 V

It will be learned that in Comparative Example 1, V_{oc} is lower than that of Example 1 and the conversion efficiency is low correspondingly.

### (Example 2)

A titanium isopropoxide which was a binder was diluted with an organic solvent (butanol) to prepare a titanium alkoxide solution (titanium isopropoxide concentration, 2 mols/L). It was confirmed by the infrared absorption analysis (IR) that the isopropoxyl groups in the titanium isopropoxide had been partly substituted with butyl groups in the titanium alkoxide solution.

To the titanium alkoxide solution were added fine titanium dioxide particles (commercialized titania particles having a particle diameter of 15 to 350 nm), acetyl acetone (dispersant), decanol (porosity promotor) and a butanol/ethanol mixed solvent (mixing ratio, 50/50), and the mixture was subjected to the dispersion treatment of stirring and shaking to prepare a paste of fine semiconductor oxide particles. It was confirmed by the IR that a chelate bond had been formed by the titanium atoms in the titanium isopropoxide. The composition of the paste was as follows:

Composition of paste:
Solid component concentration, 20% by weight
Binder (titanium isopropoxide), 20 parts by weight per 100 parts by weight of the fine titanium dioxide particles
Dispersant (acetylacetone), 6 parts by weight per 100 parts by weight of the fine titamium dioxide particles
Porosity promotor (decanol), 2 parts by weight per 100 parts by weight of the fine titanium dioxide particles

Next, the paste prepared above was applied onto the aluminum plate treated with chromic phosphate (thickness of 0.3 mm which was the same as the one used in Example 1), and was fired at 450°C for 0.5 hours to form a titanium oxide layer of a thickness of 8 µm. The surface of the titanium oxide layer was observed by using an electron microscope and it was confirmed from its photograph that the titanium oxide layer that was formed was a porous layer having pore sizes of project area of not smaller than 10,000 nm² at a ratio of 30% of all pores per an area of 1 µm x 1 µm.

A dye-sensitized solar cell was fabricated in the same manner as in Example 1 but forming the semiconductor oxide porous layer (titanium oxide layer) in a manner as described above.

The obtained solar cell was measured for its conversion efficiency as follows with a cell area of 1 cm²:
Conversion efficiency, 3.60%
FF (internal resistance), 0.55
J_{sc} (Short-circuit current density), 11.0 mA/cm²
V_{oc} (Open-circuit voltage), 0.60 V

### (Example 3)

A paste for forming an semiconductor oxide layer having a solid component concentration of 20% by weight was prepared in quite the same manner as in Example 2 but using neither the acetylacetone (dispersant) nor the decanol (porosity promotor). By using the above paste, a titanium oxide layer of a thickness of 8 µm was formed on the aluminum plate that had been treated with chromic phosphate in quite the same manner as in Example 2.

The surface of the titanium oxide layer was observed by using an electron microscope and it was confirmed from its photograph that the titanium oxide layer that was formed possessed pore sizes of project area of not smaller than 10,000 nm² at a ratio of 20% of all pores per an area of 1 µm x 1 µm.

A dye-sensitized solar cell was fabricated in the same manner as in Example 1 but forming the semiconductor oxide porous layer (titanium oxide layer) in a manner as described above. The obtained solar cell was measured for its conversion efficiency as follows with a cell area of 1 cm²:
Conversion efficiency, 1.84%
FF (internal resistance), 0.56
J_{sc} (Short-circuit current density), 4.32 mA/cm²
V_{oc} (Open-circuit voltage), 0.76 V

## Claims

1. A dye-sensitized solar cell including a negative electrode structure, an opposing electrode structure having a transparent conducting substrate, and an electrolyte layer provided between said negative electrode structure and the opposing electrode, said negative electrode structure having a metal electrode substrate and an semiconductor oxide layer carrying a dye, wherein a chemical conversion treatment film is formed on a surface of said metal electrode substrate, and said semiconductor oxide layer is formed on said chemical conversion treatment film and wherein the metal electrode substrate is made from aluminum or iron

2. The dye-sensitized solar cell according to claim 1, wherein said chemical conversion treatment film has a thickness in a range of 5 to 500 nm.

3. The dye-sensitized solar cell according to claim 1, wherein said semiconductor oxide layer, when the surface thereof is observed by using an electron microscope, has pore sizes of project area of not smaller than 10, 000 nm² in a number of 5 to 80% of all pores in the surface thereof of a size of an area of 1 µm x 1 µm.

4. The dye-sensitized solar cell according to claim 3, wherein said semiconductor oxide layer has a thickness of 1 to 15 µm.

## Patentansprüche

1. Farbstoff-sensibilisierte Solarzelle, die Folgendes einschließt: eine negative Elektrodenstruktur, eine Gegenelektrodenstruktur mit einem transparenten leitenden Substrat und eine Elektrolytschicht, die zwischen der genannten negativen Elektrodenstruktur und der Gegenelektrode bereitgestellt ist, wobei die genannte negative Elektrodenstruktur ein Metallelektrodensubstrat und eine Halbleiteroxidschicht, die einen Farbstoff mitführt, aufweist, worin ein Film der chemischen Konversionsbehandlung auf einer Oberfläche des genannten Metallelektrodensubstrats gebildet ist und die genannte Halbleiteroxidschicht auf dem genannten Film der chemischen Konversionsbehandlung gebildet ist und worin das Metallelektrodensubstrat aus Aluminium oder Eisen hergestellt ist.

2. Farbstoff-sensibilisierte Solarzelle nach Anspruch 1, worin der genannte Film der chemischen Konversionsbehandlung eine Dicke im Bereich von 5 bis 500 nm aufweist.

3. Farbstoff-sensibilisierte Solarzelle nach Anspruch 1, worin die genannte Halbleiteroxidschicht, wenn die Oberfläche davon unter Verwendung eines Elektronenmikroskops betrachtet wird, Porengrößen der Projektionsfläche von nicht kleiner als 10 000 nm² in einer Zahl von 5 bis 80 % aller Poren in der Oberfläche davon von einer Größe einer Fläche von 1 µm x 1 µm aufweist.

4. Farbstoff-sensibilisierte Solarzelle nach Anspruch 3, worin die genannte Halbleiteroxidschicht eine Dicke von 1 bis 15 µm aufweist.

## Revendications

1. Cellule à pigment photosensible comportant une structure d'électrode négative, une structure d'électrode opposée ayant un substrat conducteur transparent, et une couche d'électrolyte fournie entre ladite structure d'électrode négative et l'électrode opposée, ladite structure d'électrode négative ayant un substrat d'électrode métallique et une couche d'oxyde semi-conducteur portant un pigment, dans laquelle un film de traitement de conversion chimique est formé sur une surface dudit substrat d'électrode métallique, et ladite couche d'oxyde semiconducteur est formée sur ledit film de traitement de conversion chimique et dans lequel le substrat d'électrode métallique est réalisé en aluminium ou en fer.

2. Cellule à pigment photosensible selon la revendication 1, dans laquelle ledit film de traitement de conversion chimique a une épaisseur dans une plage de 5 à 500 nm.

3. Cellule à pigment photosensible selon la revendication 1, dans laquelle ladite couche d'oxyde semi-conducteur, quand sa surface est examinée au microscope électronique, présente des tailles de pores dans la zone de projet supérieures à 10 000 nm² dans un nombre de 5 à 80% de tous les pores de sa surface d'une aire de 1 µm x 1 µm.

4. Cellule à pigment photosensible selon la revendication 3, dans laquelle ladite couche d'oxyde semi-conducteur a une épaisseur de 1 à 15 µm.
